# EUROPEAN PATENT SPECIFICATION

(11) **EP 1 929 560 B1**
(45) Date of publication and mention of the grant of the patent: **06.01.2016**
(21) Application number: 06776795.4
(22) Date of filing: 11.08.2006
(51) Int. Cl.: H01L 51/54

(54) **NEUTRALIZED ANODE BUFFER LAYER TO IMPROVE PROCESSING AND PERFORMANCES OF ORGANIC LIGHT EMITTING DEVICES AND FABRICATION METHOD THEREOF**
NEUTRALISIERTE ANODENPUFFERSCHICHT ZUR VERBESSERUNG DER VERARBEITUNG UND LEISTUNGSFÄHIGKEITEN ORGANISCHER LICHTEMITTIERENDER BAUELEMENTE UND DEREN HERSTELLUNGSMETHODE
COUCHE TAMPON D'ANODE NEUTRALISÉE POUR AMÉLIORER LE TRAITEMENT ET LES PERFORMANCES DE DISPOSITIFS ÉLECTROLUMINESCENTS ORGANIQUES ET SA MÉTHODE DE FABRICATION

(30) Priority: 30.09.2005 US 242180
(43) Date of publication of application: 11.06.2008
(73) Proprietor: OSRAM OLED GmbH, 93049 Regensburg (DE)
(72) Inventor: ALLEMAND, Pierre-Marc, San Jose, California 95110 (US)
(74) Representative: Epping - Hermann - Fischer
(86) International application number: PCT/EP2006/007978
(87) International publication number: WO 2007/039014

(56) References cited:
- EP-A2- 1 505 664
- WO-A-2005/015654
- JP-A- 2005 108 504
- US-A1- 2003 057 403
- US-A1- 2003 062 510
- US-A1- 2004 254 297
- US-A1- 2005 129 857
- US-A1- 2005 151 468
- ALESHIN A N ET AL: "TRANSPORT PROPERTIES OF POLY(3,4-ETHYLENEDIOXYTHIOPHENE)/ POLY(STYRENESULFONATE)" SYNTHETIC METALS, ELSEVIER SEQUOIA, LAUSANNE, CH, vol. 94, no. 2, 30 April 1998 (1998-04-30), pages 173-177, XP000961483 ISSN: 0379-6779

## Description

### BACKGROUND

### 1. Field of the Invention

This invention relates generally to the art of thin film device processing and fabrication. More specifically, the invention relates to the fabrication of Organic Light Emitting Diode devices and displays.

### 2. Related Art

Display and lighting systems based on LEDs (Light Emitting Diodes) have a variety of applications. Such display and lighting systems are designed by arranging a plurality of photo-electronic elements ("elements") such as arrays of individual LEDs. LEDs that are based upon semiconductor technology have traditionally used inorganic materials, but recently, the organic LED ("OLED") has come into vogue for certain lighting and display applications. Examples of other elements/devices using organic materials include organic solar cells, organic transistors, organic detectors, biochips, and organic lasers.

An OLED is typically comprised of two or more thin at least partially conducting organic layers (e.g., a buffer layer) which transports holes (or electrons) and an emissive layer (EL) which emits light upon hole-electron recombination therein) which are sandwiched between two electrodes, an anode and a cathode. Under an applied potential, the anode injects holes into the ABL which then transports them to the EL, while the cathode injects electrons directly to the EL. The injected holes and electrons each migrate toward the oppositely charged electrode and recombine to form an exciton in the EL. The exciton relaxes to a lower energy state by emission of radiation i.e. light. Typically, polymer-based OLED devices have been fabricated by using anode buffer layer (ABL) materials (also called Hole Transport Layer or HTL) which are based on doped conducting polymers such as PEDOT (polyethylenedioxythiophene) or PANI (polyaniline). PEDOT is often mixed with an acid such as PSS (polystyrenesulfonic acid). One of the most commonly used ABL materials is Baytron P VP CH8000, available from HC Starck Corporation. Baytron P VP CH8000 has a PEDOT:PSS weight ratio of 1:20, and a resistivity of around 100 kOhm-cm. Baytron P VP CH8000 is appropriate for applications such as passive matrix displays which do not require further patterning/processing and provides good photopic efficiency and reasonably low operating voltage requirements. However, with very few exceptions, these device structures do not exhibit desirable lifetimes.

One problem associated with the use of Baytron CH8000 solutions is that these solutions are very acidic, thus causing corrosion of the processing equipment and dissolution of the ITO layer of the glass substrate. Another problem is that the dried films of Baytron are quite hygroscopic. Absorption of water in the Baytron film can cause undesired corrosion problems. Another complication with materials such as Baytron CH8000 is that upon baking, the material cross-links and becomes insoluble in water and therefore difficult to remove from unwanted areas of the device.

It would be desirable to fabricate an ABL with better lifetimes and less burdensome processing requirements.

In this context patent application US 2004/254297 A1 discloses compositions comprising aqueous dispersions of polythiophenes having homopolymers or co-polymers of the formulas 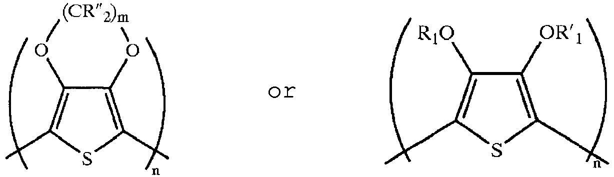 and at least one colloid-forming polymeric acid. Methods of making such compositions and using them in organic electronic devices are further provided.

Moreover patent application US 2003/057403 A1 describes an electroluminescent device comprising a transparent or translucent support, a transparent or translucent first electrode, a second conductive electrode and an electroluminescent phosphor layer sandwiched between the transparent or translucent first electrode and the second conductive electrode, wherein the first and second electrodes each comprise a polymer or copolymer or a 3,4-dialkoxythiophene, which may be the same or different, in which the two alkoxy groups may be the same or different or together represent an optionally substituted oxy-alkylene-oxy bridge. The patent application further discloses a display comprising the above-mentioned electroluminescent device, a lamp comprising the above-mentioned electroluminescent device and manufacturing processes for the above-mentioned electroluminescent devices, as well as the use of such devices for the integrated backlighting of static and dynamic posters and signage.

### BRIEF DESCRIPTION OF THE DRAWINGS

FIG. 1 illustrates a process flow for fabricating an ABL according to at least one embodiment of the invention.
FIG. 2 shows a cross-sectional view of an embodiment of an OLED device 405 according to at least one embodiment of the invention.
FIG. 3A illustrates current-voltage curves for illustrative examples.
FIG. 3(B) illustrates luminous efficiency for the same four devices as FIG. 3(A).
FIG. 4 illustrates normalized lifetime data for each of the four above-mentioned devices.
FIG. 5 illustrates voltage driving requirements for each of the four above-mentioned devices when driven under DC conditions.
FIGs 6A and 6B compare water absorption rates for ABL films using conventional ABL material versus those using fully neutralized ABL material under different baking conditions.
FIG. 7 illustrates the corrosive effect upon ITO for ABL films using conventional ABL material versus those using fully neutralized ABL material.

### DETAILED DESCRIPTION OF THE INVENTION

In describing the various embodiments of the invention, the terms "mixture" and "solution" are intended to have an identical meaning. They refer to a combination or blending of compounds, liquid, solid and gaseous which chemically react and/or physically blended together.

What is disclosed is an ABL formulation that yields better device lifetimes. In at least one embodiment of the invention, an acidic ABL material (such as PEDOT:PSS blend) is neutralized fully by a volatile base wherein said volatile base comprises at least one of monoalkylamines (NH₂R), dialkylamines (NHR₂), trialkylamines (NR₃) such as trimethylamine, triethylamine, and alkylarylamines. The neutralized ABL solution is then utilized to form the ABL layer. In at least one embodiment, the process for preparing the ABL solution includes measuring the needed amount of the acidic ABL material, calculating the amount of H⁺ equivalents are present, and adding an identical amount of a volatile base. If the surface tension of the solution is not low enough, surfactants can be added to ensure better layer processing.

The lifetimes at multiplexed driving conditions in OLED devices using neutralized (partially or fully) ABL solutions were increased in comparison to identical OLED devices using conventional acidic (non-neutralized) ABL material. Also, the initial large decays in luminance prevalent in OLED devices using conventional non-neutralized ABL material was not as prominent in neutralized ABL solution OLED devices. In addition, the ABL when fabricated using neutralized ABL solution in accordance with the invention was found to be easier to remove after baking when compared with conventionally used materials. An ABL based on a neutralized solution is also less corrosive to the substrate material, such as ITO, on which it is fabricated. This may in part be due to reduction in acid content of the ABL and also, an observed reduction in the level of water absorbed by neutralized ABL compared to non-neutralized ABL. Also, the in-plane resistivity of ABLs fabricated using neutralized solution were high enough to be suitable for passive matrix display applications.

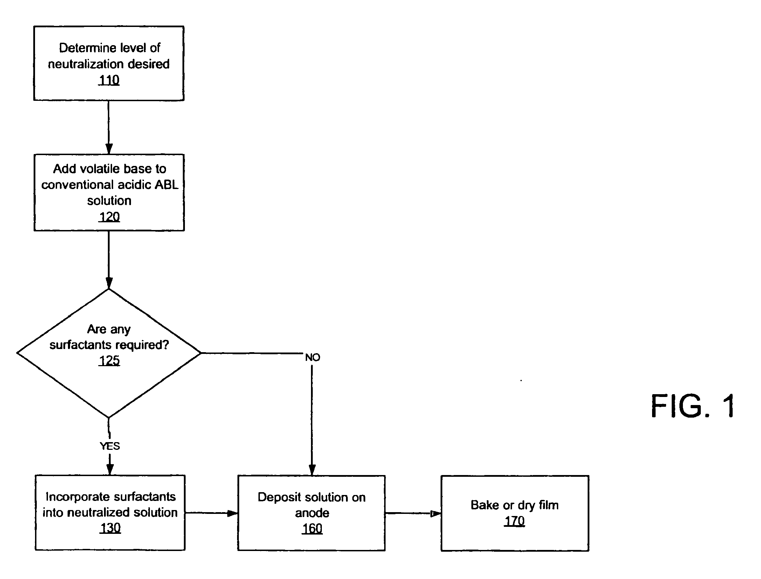

FIG. 1 illustrates a process flow for fabricating an ABL according to at least one embodiment of the invention. First the level of desired neutralization is determined (block 110). This may be done by experimentation as differing levels of neutralization may be required depending upon the specific acidic ABL material and specific volatile base being used. The determined level of neutralization will affect device performance, processability and lifetimes. Once determined for a specific OLED device being manufactured, it can of course be held constant. 100% or fully neutralized ABL is the most effective (see below). The level of neutralization desired can be achieved by calculating, measuring or experimentally determining how many equivalents of H+ are present in the acidic ABL material. This is well-known in the field of chemistry and will not be discussed in-depth. The same number of equivalents of a volatile base is then added to the solution of the conventional acidic ABL material (block 120). Next, there may be surfactants or other additives which are required or desired (checked at block 125). If so, then the surfactants or other additives are incorporated into the solution (block 130). The neutralized solution is then deposited onto the anode (of an OLED device) (block 160). There are many suitable deposition techniques, some selective and non-selective. Spin-coating is one common technique that can be used in depositing the neutralized ABL solution. Once the solution is deposited, it begins to dry into a film and can be baked in order to harden and stabilize it (block 170). In some embodiments of the invention, the neutralized ABL solution is not baked but merely dried under room temperature in vacuum conditions. Where baking is employed, the bake temperature can be any suitable temperature (for instance 200 degrees C or greater) and any suitable time period which would give the desired result.

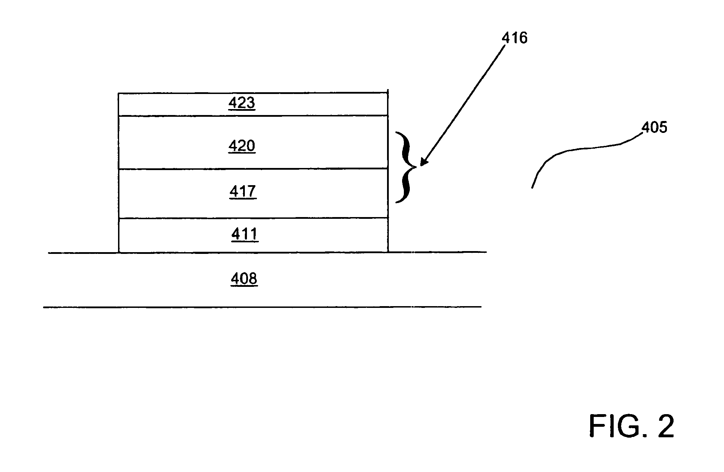

FIG. 2 shows a cross-sectional view of an embodiment of an OLED device 405 according to at least one embodiment of the invention. The OLED device 405 may represent one OLED pixel or sub-pixel of a larger OLED display. OLED device 405 is a passive-matrix device since it does not contain its own switching mechanism as with active matrix devices. As shown in FIG. 2, the OLED device 405 includes a first electrode 411 on a substrate 408. As used within the specification and the claims, the term "on" includes when layers are in physical contact or when layers are separated by one or more intervening layers. The first electrode 411 may be patterned for pixilated applications or unpatterned for backlight or lighting applications.

One or more organic materials are deposited above first electrode 411 to form one or more organic layers of an organic stack 416. The organic stack 416 is on the first electrode 411. The organic stack 416 includes an anode buffer layer ("ABL") 417 and light emitting polymer (LEP) layer 420. The OLED device 405 also includes a second electrode 423 on the organic stack 416. Other layers than that shown in FIG. 2 may also be added including barrier, charge transport, charge injection, planarizing, diffracting, and interface layers between or among any of the existing layers as desired. Some of these layers, in accordance with the invention, are described in greater detail below.

### Substrate 408:

The substrate 408 can be any material that can support the organic and metallic layers on it. The substrate 408 can be transparent or opaque (e.g., the opaque substrate is used in top-emitting devices). By modifying or filtering the wavelength of light which can pass through the substrate 408, the color of light emitted by the device can be changed. The substrate 408 can be comprised of glass, quartz, silicon, plastic, or stainless steel; preferably, the substrate 408 is comprised of thin, flexible glass. The preferred thickness of the substrate 408 depends on the material used and on the application of the device. The substrate 408 can be in the form of a sheet or continuous film. The continuous film can be used, for example, for roll-to-roll manufacturing processes which are particularly suited for plastic, metal, and metallized plastic foils. A single substrate 408 is typically used to construct a larger OLED display containing many pixels such as OLED device 405 which are then arranged in some pattern.

### First Electrode 411:

In one configuration, the first electrode 411 functions as an anode (the anode is a conductive layer which serves as a hole-injecting layer and which comprises a material with work function greater than about 4.5 eV). Typical anode materials include metals (such as platinum, gold, palladium, indium, and the like); metal oxides (such as lead oxide, tin oxide, ITO (Indium Tin Oxide), and the like); graphite; doped inorganic semiconductors (such as silicon, germanium, gallium arsenide, and the like); and doped conducting polymers (such as polyaniline, polypyrrole, polythiophene, and the like).

The first electrode 411 can be transparent, semi-transparent, or opaque to the wavelength of light generated within the device 405 depending on whether the device 405 is top-emitting or bottom-emitting. The thickness of the first electrode 411 can be from about 10 nm to about 1000 nm, preferably, from about 50 nm to about 200 nm, and more preferably, is about 100 nm. The first electrode layer 411 can typically be fabricated using any of the techniques known in the art for deposition of thin films, including, for example, vacuum evaporation, sputtering, electron beam deposition, or chemical vapor deposition.

### ABL 417:

The ABL 417 typically has a much higher hole mobility than electron mobility and is used to effectively transport holes from the first electrode 411 to the LEP layer 420. The ABL 417 can be made of polymers or small molecule materials. In accordance with the invention, the ABL 417 is formed from a solution comprising primarily an acidic ABL material and a volatile base wherein the volatile base neutralizes all of the acidic groups in the acidic ABL material, wherein said volatile base comprises at least one of monoalkylamines (NH₂R), dialkylamines (NHR₂), trialkylamines (NR₃) such as trimethylamine, triethylamine, and alkylarylamines. In some embodiments of the invention, the acidic ABL material is PEDOT:PSS. Not claimed but described is the case that the volatile base is NH₃. With a volatile base such as NH₃, the expectation is that upon baking/drying the ammonia would entirely dissipate leaving the acidic groups again. Unexpectedly, this was found not to be the case. The ammonia salts of the PSS in neutralized PEDOT:PSS for instance, largely remained even after baking.

Acidic ABL materials can comprise blends of a conducting polymer such as PEDOT, poly(3,4-dimethoxythiophene), poly(3-methoxythiophene), poly(isothianaphthene) and its derivatives, poly(pyrrole) and its derivatives, PANI and its derivatives, with an acid or polyacid such as poly(styrene sulfonic acid) (PSS), poly(2-acrylamido-2-methyl-l-propanesulfonic acid), sulfonated perfluorinated resins (such as NAFION™ from DuPont Chemical Corp.), 2-acrylamido-2-methyl-1-propanesulfonic acid, camphorsulfonic acid, dodecylbenzenesulfonic acid, poly(acrylic) acid, and combinations thereof. Volatile bases that are utilized in the invention include, monoalkylamines (NH₂R), dialkylamines (NHR₂), trialkylamines (NR₃) such as trimethylamine, triethylamine, and so on, and alkylarylamines. Not claimed but described are ammonia (NH₃), arylamines and aromatic heterocycles such as pyridines, pyrroles, imidazoles and triazoles.

Ionic or non-ionic surfactants can also be added to the solution to improve its processability. The solution can be deposited (e.g. by spin coating) onto first electrode 411. The deposited solution dries into a film. The deposited solution can be baked at a high temperature until hardened sufficiently or simply allowed to vacuum dry at room temperatures.

Described is a PEDOT:PSS material that is neutralized with 30 wt % ammonia (NH₃) as an aqueous solution. Furthermore described is PEDOT:PSS that was fully neutralized by the 30% ammonia such that all of the H⁺ ions present in the PSS are neutralized. In some illustrative cases, the acidic ABL material was only partially neutralized, for instance at 50% or 75% neutralization. The neutralization can effectively bring the pH of the ABL from between about 1.5 to about 8. These mixtures are dark blueish-purple and characterized by an absorption maximum at 850 nm and a weak shoulder at 500 nm, which is slightly different from the absorption found in Baytron CH8000 and other PEDOT:PSS materials.

Once the neutralized solution is prepared, it is deposited on the first electrode 411. The neutralized solution used in fabricating ABL 417 can be deposited onto first electrode 411 using selective deposition techniques or non-selective deposition techniques. Examples of selective deposition techniques include, for example, ink jet printing, flex printing, and screen printing. Examples of non-selective deposition techniques include, for example, spin coating, dip coating, web coating, and spray coating. Once deposited the solution is dried into a film. The dried film becomes ABL 417. In at least one embodiment, the drying of the neutralized solution into film is achieved by vacuum drying the entire device after deposition at room temperatures. In other embodiments, the drying of the neutralized film comprises baking the device after deposition at 200 degrees C or greater. In other embodiments, the baking temperature is anywhere between 50 degrees C or greater. The time of baking and/or drying can be varied as desired.

The ABL 417 can have a thickness from about 5 nm to about 1000 nm, and is conventionally used from about 50 to about 250 nm.

In one or more embodiments of the invention, an ABL layer of about 100 nm is used.

Neutralized ABL films which are baked at 200 °C are easier to remove with water than non-neutralized films on the same deposition surface. This is believed due to the diminished capability of neutral ABL material to cross-link as efficiently as the acidic ABL material. The water absorption rate of fully neutralized ABL films is less than that convention acidic ABL films. Corrosion of the underlying anode (first electrode 411) is almost completely suppressed in neutralized ABL films due to the neutrality of the solution. The voltage-current characteristics, resistivity and viscosity are nearly the same or sometimes better with neutralized ABL films compared to conventional acidic ABL films, as shown below in the case of Baytron CH8000. Importantly, the lifetime of OLED devices using neutralized ABL films is improved over films using conventional acidic ABL films (also shown in the accompanying FIGs).

### LEP Layer 420:

For organic LEDs (OLEDs), the LEP layer 420 contains at least one organic material that emits light. These organic light emitting materials generally fall into two categories. The first category of OLEDs, referred to as polymeric light emitting diodes, or PLEDs, utilize polymers as part of LEP layer 420. The polymers may be organic or organo-metallic in nature. As used herein, the term organic also includes organo-metallic materials. Preferably, these polymers are dissolved in an organic solvent, such as toluene or xylene, and spun (spin-coated) onto the device, although other deposition methods are possible. Devices utilizing polymeric active electronic materials in LEP layer 420 are especially preferred.

Optionally, LEP layer 420 may include a light responsive material that changes its electrical properties in response to the absorption of light. Light responsive materials are often used in detectors and solar panels that convert light energy to electrical energy.

The light emitting organic polymers in the LEP layer 420 can be, for example, EL polymers having a conjugated repeating unit, in particular EL polymers in which neighboring repeating units are bonded in a conjugated manner, such as polythiophenes, polyphenylenes, polythiophenevinylenes, or poly-p-phenylenevinylenes or their families, copolymers, derivatives, or mixtures thereof. More specifically, the organic polymers can be, for example: polyfluorenes; poly-p-phenylenevinylenes that emit white, red, blue, yellow, or green light and are 2-, or 2, 5- substituted poly-p-pheneylenevinylenes; polyspiro polymers. Preferred organic emissive polymers include Light Emitting Polymers ("LEPs") that emit green, red, blue, or white light or their families, copolymers, derivatives, or mixtures thereof. Other polymers include polyspirofluorene-like polymers.

In addition to polymers, smaller organic molecules that emit by fluorescence or by phosphorescence can serve as a light emitting material residing in LEP layer 420. Unlike polymeric materials that are applied as solutions or suspensions, small-molecule light emitting materials can also be deposited through evaporative, sublimation, or organic vapor phase deposition methods. Combinations of PLED materials and smaller organic molecules can also serve as active electronic layer. For example, a PLED may be chemically derivatized with a small organic molecule or simply mixed with a small organic molecule to form LEP layer 420.

In addition to active electronic materials that emit light, LEP layer 420 can include a material capable of charge transport. Charge transport materials include polymers or small molecules that can transport charge carriers. For example, organic materials such as polythiophene, derivatized polythiophene, oligomeric polythiophene, derivatized oligomeric polythiophene, pentacene, compositions including C60, and compositions including derivatized C60 may be used. LEP layer 420 may also include semiconductors, such as silicon or gallium arsenide.

The LEP layer 420 typically has a thickness of greater than 80 nm and preferably, between 40 and 125 nm.

All of the organic layers such as ABL 417 and LEP layer 420 can be ink-jet printed by depositing an organic solution or by spin-coating, or other deposition techniques. This organic solution may be any "fluid" or deformable mass capable of flowing under pressure and may include solutions, inks, pastes, emulsions, dispersions and so on. The liquid may also contain or be supplemented by further substances which affect the viscosity, contact angle, thickening, affinity, drying, dilution and so on of the deposited drops. Further, each of the layers 417 and 420 may be cross-linked or otherwise physically or chemically hardened as desired for stability and maintenance of certain surface properties desirable for deposition of subsequent layers.

### Second Electrode (423)

In one embodiment, second electrode 423 functions as a cathode when an electric potential is applied across the first electrode 411 and second electrode 423. In this embodiment, when an electric potential is applied across the first electrode 411, which serves as the anode, and second electrode 423, which serves as the cathode, photons are released from active electronic layer 420 that pass through first electrode 411 and substrate 408.

While many materials, which can function as a cathode, are known to those of skill in the art, most preferably a composition that includes aluminum, indium, silver, gold, magnesium, calcium, and barium, or combinations thereof, or alloys thereof, is utilized. Aluminum, aluminum alloys, and combinations of magnesium and silver or their alloys can also be utilized.

Preferably, the thickness of second electrode 423 is from about 10 to about 1000 nanometers (nm), more preferably from about 50 to about 500 nm, and most preferably from about 100 to about 300 nm. While many methods are known to those of ordinary skill in the art by which the first electrode material may be deposited, vacuum deposition methods, such as physical vapor deposition (PVD) are preferred. Other layers (not shown) such as a barrier layer and getter layer may also be used to protect the electronic device. Such layers are well-known in the art and are not specifically discussed herein.

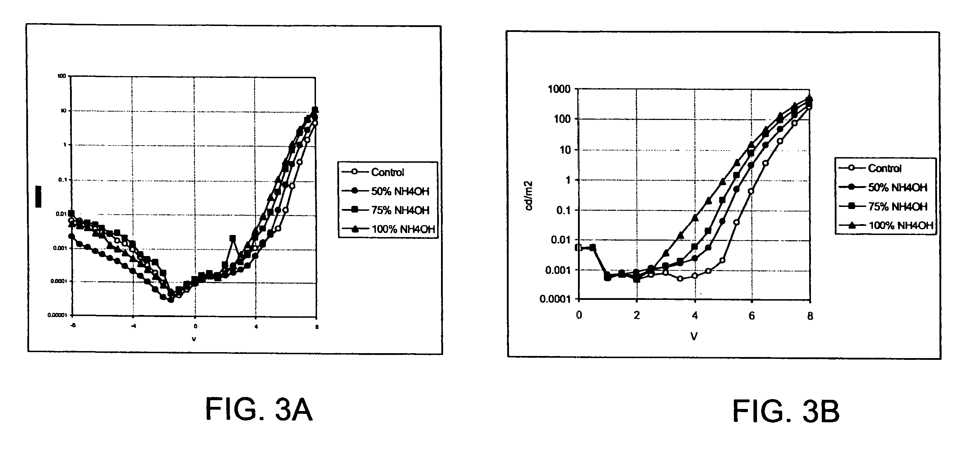

FIG. 3A illustrates current-voltage curves for various described devices. There were four devices tested with the following characteristics. Each device used PEDOT:PSS (Baytron CH8000) for the acidic ABL and an aqueous solution of 30% NH4OH with varying levels of neutralization 0% (a "Control" device), 50%, 75% and 100% neutralization levels were tested. The ABL was fabricated to have a thickness of about 100 nm in each device and each device used a white-emitting polyfluorene-based LEP with a thickness of 80 nm. The substrates were glass (0.7 mm thickness) coated with an anode of ITO (indium tin oxide) (100 to 120 nm). The cathode was formed by a composite of LiF and calcium followed by aluminum. The devices were then encapsulated.

The plot of current density (milliamperes/centimeter²) versus voltage shows that all devices had roughly similar characteristics. Notably, there is a current density of a reverse current of less than 10⁻³ mA/cm² at -2 volts of applied potential. FIG. 3(B) illustrates luminous efficiency for the same four devices as FIG. 3(A). The luminous efficiency as expressed in terms of brightness (candela/meter²) versus voltage shows that devices with a higher neutralization level show better efficiency and that any neutralization even 50% neutralization, yields a more efficient device than the convention control device which has no neutralization.

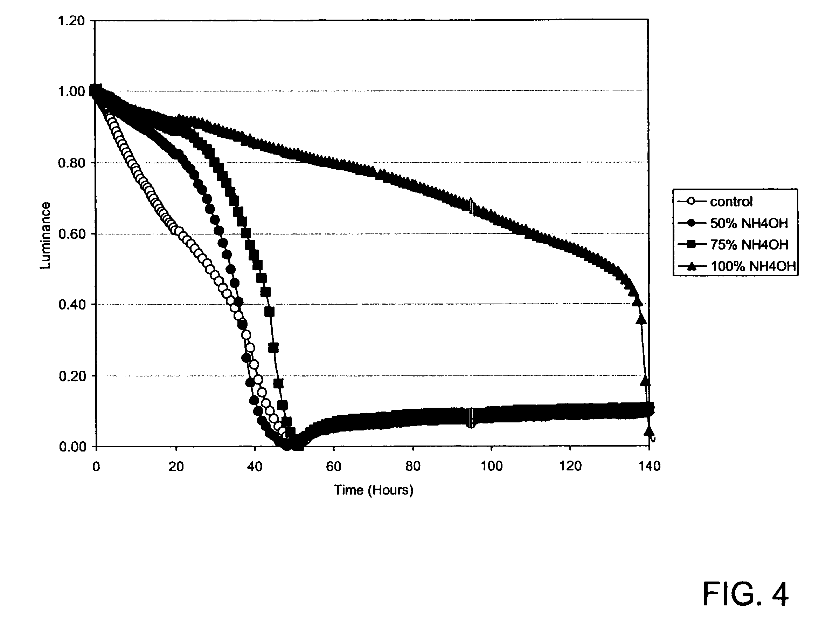

FIG. 4 illustrates normalized lifetime data for each of the four above-mentioned devices. It can be seen that the lifetime of the devices made with compositions having greater neutralization level ABL is better when compared to the same devices made with compositions having a lower neutralization level ABL. There is less of an initial luminance drop with neutralized ABL devices, and with 100% neutralized devices, the drop in luminance over time is more linear.

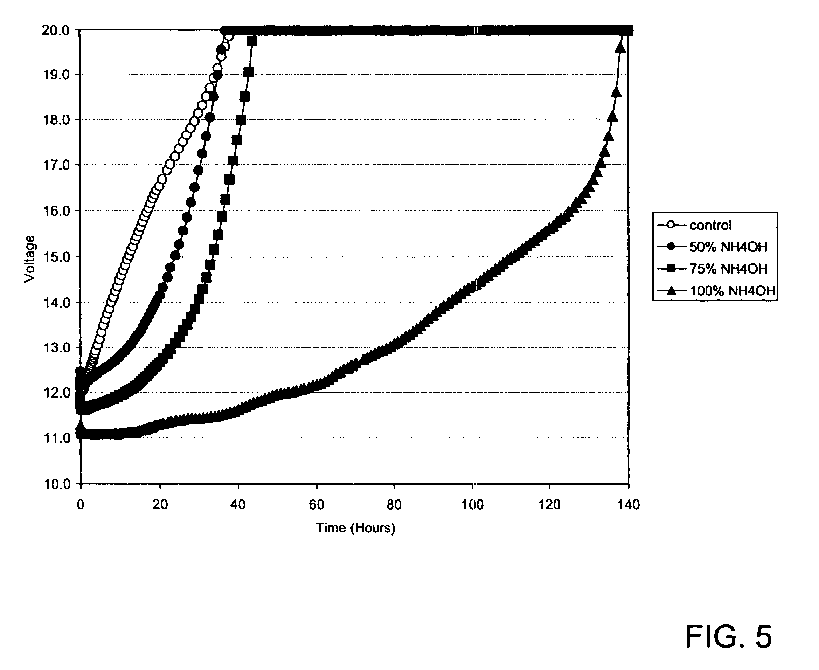

FIG. 5 illustrates voltage driving requirements for each of the four above-mentioned devices when driven under DC conditions. Advantageously, the fully neutralized device requires a lower driving voltage and, again, a more linear change in required voltage over time than compared to the control device and partially neutralized devices.

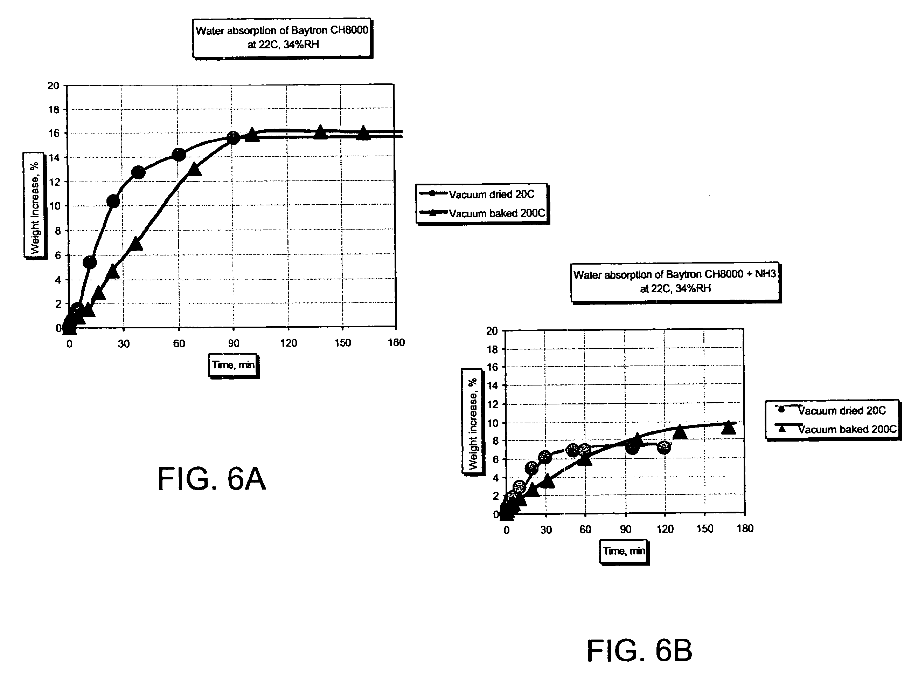

FIGs 6A and 6B compare water absorption rates for ABL films using conventional ABL material versus those using fully neutralized ABL material under different baking conditions. The water absorption rate of thick films of Baytron CH8000 was measured at 22 °C and 34% relative humidity. A set of films was vacuum dried at 20 °C, while another was vacuum baked at 200 °C. The resulting water absorption is shown in FIG. 6A. After about 90 minutes, both the vacuum dried and baked films of non-neutralized conventional Baytron CH8000 showed a weight increase of about 15-16%. By contrast, as shown in FIG. 6B, films fabricated from the same Baytron CH8000 that was then neutralized fully with ammonia showed only a 7-9% weight increase after 90 minutes in the vacuum drying and 200 °C baking cases.

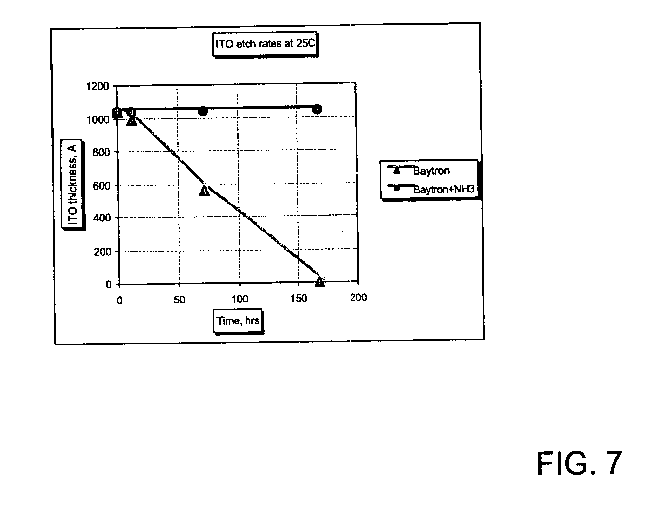

FIG. 7 illustrates the corrosive effect upon ITO for ABL films using conventional ABL material versus those using fully neutralized ABL material. The neutrality of the fully neutralized ABL films suppresses the corrosive effects of the ABL upon anode materials like ITO, as shown in FIG. 7. Conventional ABL (Baytron) eventually corroded the ITO completely within 160-165 hours. With fully neutralized ABL there was hardly if any corrosion of the ITO anode. The process of neutralizing the ABL in accordance with the invention may thus have beneficial impacts on processing of films for OLEDs such as corrosion of inkjet print heads.

With a volatile base such as NH₃, the expectation is that upon baking/drying the ammonia would entirely dissipate leaving the acidic groups again. Unexpectedly, this was found not to be the case. The ammonia salts of the PSS in neutralized PEDOT:PSS, for instance, largely remained even after baking. This was shown experimentally using elemental analysis of neutralized PEDOT:PSS (Baytron CH8000) which had been baked in a vacuum at 200 °C for 30 minutes. The results were as follows:

| Baytron CH8000 + NH3 | | | | | | |
|---|---|---|---|---|---|---|
| Calculated for (C8H11NSO3)15.22(C6H4SO2)1.00 | | | Found | | | |
| El | At.Wt | % | before bake | | after bake | |
| C | 12.011 | 47.91 | C | 48.36 | C | 47.33 |
| H | 1.0079 | 5.39 | H | 6.21 | H | 5.47 |
| N | 14.007 | 6.66 | N | 6.15 | N | 5.4 |
| O | 15.999 | 23.81 | | | | |
| S | 32.066 | 16.24 | S | 15.23 | S | 15.48 |

The above chart shows that after baking, a substantial and in fact the almost entire quantity of NH₃ before baking remained even after baking. There was only a small loss of N after baking. This implies that the ammonium polystyrene sulfonate salt is quite stable at 200 °C and that the ammonia is not lost due to baking as one could expect.

The embodiments of the invention are illustrated in which it is primarily incorporated within an OLED display. The OLED display/device described earlier can be used within displays in applications such as, for example, computer displays, information displays in vehicles, television monitors, telephones, printers, area and general lighting, backlighting and illuminated signs.

## Claims

1. An organic light emitting device (405), comprising:
an anode (411);
an anode buffer layer (ABL) (417) disposed upon said anode (411), said anode buffer layer (417) containing an acidic ABL material and a volatile base, the acidic groups in the acidic ABL material being fully neutralized by the volatile base; and
a light emitting layer (420) disposed on said anode buffer layer, said light emitting layer (420) capable of emitting light upon electron hole recombination therein, wherein said volatile base comprises at least one of monoalkylamines (NH₂R), dialkylamines (NHR₂), trialkylamines (NR₃) such as trimethylamine, triethylamine, and alkylarylamines.

2. The organic light emitting device (405) of claim 1 further comprising:
a cathode (423) disposed on said light emitting layer (420).

3. The organic light emitting device (405) of any of claims 1 and 2 further comprising:
a substrate (408), said anode (411) disposed upon said substrate (408).

4. The organic light emitting device (405) of any of claims 1 to 3 wherein said light emitting layer (420) is a conjugated polymer.

5. The organic light emitting device (405) of any of claims 1 to 4 wherein said acidic groups comprises at least one of:
poly(sterene sulfonic acid), poly(2-acrylamido-2-methyl-1-propanesulfonic acid), poly(acrylic acid), a sulfonated perfluorinated resin, and salts of said polyacids.

6. The organic light emitting device (405) of any of claims 1 to 5 wherein said acidic ABL material is PEDOT:PSS.

7. A method of fabricating an anode buffer layer (417) for an organic light emitting device (405), said method comprising:
forming a solution of acidic ABL material solvated in a volatile base such that acidic groups in the acidic ABL material are fully neutralized by the volatile base; and
depositing said solution onto an anode of said organic light emitting device (405), wherein said volatile base comprises at least one of monoalkylamines (NH₂R), dialkylamines (NHR₂), trialkylamines (NR₃) such as trimethylamine, triethylamine, and alkylarylamines.

8. A method according to claim 7 further comprising:
baking said device with the deposited solution.

9. A method according to claim 8 wherein the temperature of baking is greater than 50 °C.

10. The method according to any of claims 7 to 9 further comprising:
drying said device with the deposited solution.

## Patentansprüche

1. Organisches lichtemittierendes Bauelement (405), umfassend:
eine Anode (411);
eine Anodenpufferschicht (Anode Buffer Layer, ABL) (417), die auf der Anode (411) angeordnet ist, wobei die Anodenpufferschicht (417) ein saures ABL-Material und eine flüchtige Base enthält, wobei die sauren Gruppen in dem sauren ABL-Material vollständig durch die flüchtige Base neutralisiert sind; und
eine lichtemittierende Schicht (420), die auf der Anodenpufferschicht angeordnet ist, wobei die lichtemittierende Schicht (420) dazu in der Lage ist, nach Elektron-Loch-Rekombination darin Licht zu emittieren, wobei die flüchtige Base Monoalkylamine (NH₂R), Dialkylamine (NHR₂), Trialkylamine (NR₃), wie Trimethylamin und Triethylamin, und/oder Alkylarylamine umfasst.

2. Organisches lichtemittierendes Bauteil (405) nach Anspruch 1, ferner umfassend:
eine Kathode (423), die auf der lichtemittierenden Schicht (420) angeordnet ist.

3. Organisches lichtemittierendes Bauteil (405) nach Anspruch 1 oder 2, ferner umfassend:
ein Substrat (408), wobei die Anode (411) auf dem Substrat (408) angeordnet ist.

4. Organisches lichtemittierendes Bauteil (405) nach einem der Ansprüche 1 bis 3, wobei es sich bei der lichtemittierenden Schicht (420) um ein konjugiertes Polymer handelt.

5. Organisches lichtemittierendes Bauteil (405) nach einem der Ansprüche 1 bis 4, wobei die sauren Gruppen zumindest eins aus Poly(styrolsulfonsäure), Poly(2-acrylamido-2-methyl-1-propansulfonsäure), Poly(acrylsäure), ein sulfoniertes perfluoriertes Harz und/oder Salze der Polysäuren umfassen.

6. Organisches lichtemittierendes Bauteil (405) nach einem der Ansprüche 1 bis 5, wobei es sich bei dem sauren ABL-Material um PEDOT:PSS handelt.

7. Verfahren zur Herstellung einer Anodenpufferschicht (417) für ein organisches lichtemittierendes Bauteil (405), wobei das Verfahren umfasst:
Bilden einer Lösung von saurem ABL-Material in einer flüchtigen Base derart, dass die sauren Gruppen in dem sauren ABL-Material vollständig durch die flüchtige Base neutralisiert sind; und
Aufbringen der Lösung auf eine Anode des organischen lichtemittierenden Bauteils (405), wobei die flüchtige Base Monoalkylamine (NH₂R), Dialkylamine (NHR₂), Trialkylamine (NR₃), wie Trimethylamin und Triethylamin, und/oder Alkylarylamine umfasst.

8. Verfahren nach Anspruch 7, das ferner Folgendes umfasst:
Brennen des Bauteils mit der aufgebrachten Lösung.

9. Verfahren nach Anspruch 8, bei dem die Brenntemperatur mehr als 50°C beträgt.

10. Verfahren nach einem der Ansprüche 7 bis 9, das ferner Folgendes umfasst:
Trocknen des Bauteils mit der aufgebrachten Lösung.

## Revendications

1. Dispositif électroluminescent organique (405), comprenant :
une anode (411) ;
une couche tampon d'anode (ABL) (417) disposée sur ladite anode (411), ladite couche tampon d'anode (417) contenant un matériau ABL acide et une base volatile, les groupes acides dans le matériau ABL acide étant complètement neutralisés par la base volatile ; et
une couche électroluminescente (420) disposée sur ladite couche tampon d'anode, ladite couche électroluminescente (420) étant capable d'émettre de la lumière lors d'une recombinaison électron-trou à l'intérieur, ladite base volatile comprenant au moins une des monoalkylamines (NH₂R), dialkylamines (NHR₂), trialkylamines (NR₃) telles que triméthylamine, triéthylamine, et alkylarylamines.

2. Dispositif électroluminescent organique (405) de la revendication 1 comprenant en outre :
une cathode (423) disposée sur ladite couche électroluminescente (420).

3. Dispositif électroluminescent organique (405) de l'une quelconque des revendications 1 et 2 comprenant en outre :
un substrat (408), ladite anode (411) étant disposée sur ledit substrat (408).

4. Dispositif électroluminescent organique (405) de l'une quelconque des revendications 1 à 3 dans lequel ladite couche électroluminescente (420) est un polymère conjugué.

5. Dispositif électroluminescent organique (405) de l'une quelconque des revendications 1 à 4 dans lequel lesdits groupes acides comprennent au moins un élément parmi : le poly(acide styrènesulfonique), le poly(acide 2-acrylamido-2-méthyl-1-propanesulfonique), le poly(acide acrylique), une résine perfluorée sulfonée, et les sels desdits polyacides.

6. Dispositif électroluminescent organique (405) de l'une quelconque des revendications 1 à 5 dans lequel ledit matériau ABL acide est le PEDOT:PSS.

7. Procédé de fabrication d'une couche tampon d'anode (417) pour un dispositif électroluminescent organique (405), ledit procédé comprenant :
la formation d'une solution de matériau ABL acide solvaté dans une base volatile de telle sorte que les groupes acides dans le matériau ABL acide sont complètement neutralisés par la base volatile ;
et
le dépôt de ladite solution sur une anode dudit dispositif électroluminescent organique (405), ladite base volatile comprenant au moins une des monoalkylamines (NH₂R), dialkylamines (NHR₂), trialkylamines (NR₃) telles que triméthylamine, triéthylamine, et alkylarylamines.

8. Procédé selon la revendication 7 comprenant en outre :
la cuisson dudit dispositif avec la solution déposée.

9. Procédé selon la revendication 8 dans lequel la température de cuisson est supérieure à 50 °C.

10. Procédé selon l'une quelconque des revendications 7 à 9 comprenant en outre :
le séchage dudit dispositif avec la solution déposée.
